# EUROPÄISCHE PATENTANMELDUNG

(11) **EP 4 488 695 A1**
(43) Veröffentlichungstag der Anmeldung: **08.01.2025**
(21) Anmeldenummer: 24185974.3
(22) Anmeldetag: 02.07.2024
(51) Int. Cl.: G01R 31/08, G01R 31/12

(54) **KABELFEHLERORTUNGSVORRICHTUNG ZUR ORTUNG VON KABELFEHLERN IN EINEM NIEDERSPANNUNGSNETZ SOWIE SYSTEM DAMIT UND VERFAHREN DAFÜR**

(30) Priorität: 03.07.2023 DE 102023117497
(71) Anmelder: MS-Technik Mess- und Regelungstechnik GmbH & Co. KG, 24232 Schönkirchen (DE)
(72) Erfinder: Deutsch, Johannes, 54295 Trier (DE); Fletcher, Michael, 54516 Wittlich (DE); Döbler, Ulrich, 24145 Kiel (DE)
(74) Vertreter: Eisenführ Speiser

(57) **Zusammenfassung**

Die Erfindung umfasst eine Kabelfehlerortungsvorrichtung (10) zur Ortung von Kabelfehlern in einem Niederspannungsnetz (56) mit einem Schallwandler (16), einer Steuerung (20), einer Zeitbasis (24) und einer Datenschnittstelle (28). Die Steuerung (20) ist eingerichtet, um unter Verwendung der Datenschnittstelle (28) die Zeitbasis (24) mit der mindestens einer weiteren Kabelfehlerortungsvorrichtung (10) zu synchronisieren.

Die Erfindung umfasst ferner ein System (40) mit mindestens zwei, vorzugsweise drei Kabelfehlerortungsvorrichtungen (10) sowie ein Verfahren zum Betreiben eines Systems (40).

## Beschreibung

Die Erfindung betrifft den Bereich von Niederspannungsnetzen und hierbei insbesondere eine Ortung von Kabelfehlern in einem Niederspannungsnetz.

Ein Niederspannungsnetz dient dazu, mehrere Endverbraucher mit elektrischer Energie aus einem Mittelspannungsnetz zu versorgen. Hierzu sind die Endverbraucher durch mehrere Zweige des Niederspannungsnetzes über einen Transformator und einen Sicherungskasten mit dem Mittelspannungsnetz verbunden. Das Niederspannungsnetz umfasst für mehrere Endverbraucher jeweils einen Zweig, der ein Hauptkabel umfasst, das z. B. entlang eines Gehweges oder einer Straße unterirdisch als Erdkabel verlegt ist. An das Hauptkabel werden Abzweigkabel über Abzweigmuffen angeschlossen, um die Endverbraucher zu verbinden. Eine Abzweigmuffe dient demnach dazu, ein Abzweigkabel, das vorzugsweise ebenfalls als Erdkabel ausgebildet ist, mit dem Hauptkabel elektrisch leitend über eine elektrische Verbindung zu verbinden. Neben Abzweigmuffen sind auch Verbindungsmuffen im Streckenverlauf, beispielsweise des Hauptkabels, angeordnet, um Abschnitte des Hauptkabels zu verbinden. Im Folgenden werden Abzweigmuffen und Verbindungsmuffen auch allgemein als Muffen bezeichnet.

In einer Muffe wird ein Material zum Dichten und Isolieren, beispielsweise Harz, verwendet, um eine Isolation der elektrischen Verbindung sicherzustellen, so dass keine Feuchtigkeit an die elektrische Verbindung gelangt. Kurzschlüsse sollen so verhindert werden. Aufgrund des geringen Bauraums innerhalb einer standardisierten Muffe besteht jedoch die Möglichkeit, dass Fremdkörper oder Lufteinschlüsse in eine Muffe beim Verfüllen oder Vergießen gelangen. Meist ist die Funktion der Muffe trotz solcher Fremdkörper oder Einschlüsse über einen langen Zeitraum stabil. Es ist jedoch möglich, dass die Funktion einer Muffe, nämlich die elektrischen Verbindungen herzustellen und gegen äußere Einflüsse zu isolieren, im Laufe der Zeit nachlässt, besonders dann, wenn Fremdkörper beim Vergießen eingeschlossen wurden.

Häufig erwärmen sich nicht korrekt verfüllte Muffen, da sich beispielsweise ein Übergangswiderstand zwischen den elektrischen Verbindungen in der Muffe im Laufe der Zeit ausbildet oder Leckströme durch die Isolierung fließen. Kann diese Wärme nicht abgeführt werden, kann die Erwärmung zu irreparablen Schäden, beispielsweise zur Unterbrechung eines Leiters, eines Kurzschlusses zwischen zwei Phasen oder eines Kurzschlusses zwischen einer Phase und dem Erdpotenzial führen.

Eine Unterbrechung führt meist nur zur Unterbrechung der Versorgung eines Endverbrauchers, der mit dem entsprechenden Abzweigkabel verbunden ist. Es ist jedoch auch möglich, dass die Stammleitung unterbrochen wird und somit alle Endverbraucher hinter der Unterbrechung nicht mit Spannung versorgt werden. Eine Ortung des Fehlers ist daher in der Regel leicht möglich. Tritt ein Kurzschluss in einer Muffe auf, wird eine Sicherung im Sicherungskasten ausgelöst, die das gesamte fehlerbehaftete Hauptkabel nebst Abzweigkabeln eines Niederspannungsnetzes trennt und somit alle zugeordneten Endverbraucher keine elektrische Energie mehr erhalten. Daher ist eine Ortung eines solchen Kurzschlussfehlers sehr aufwendig.

Erschwerend zur Ortung eines Kurzschlussfehlers kommt hinzu, dass Kurzschlussfehler insbesondere zu Beginn der Entstehung des Fehlers unregelmäßig verteilt auftreten. Gerade zu Beginn der Entstehung eines Kurzschlussfehlers löst eine vorgelagerte Sicherung in der Regel nur dann aus, wenn hohe Ströme über die elektrischen Verbindungen in den Muffen fließen. Teilweise ist demnach ein Weiterbetreiben des betroffenen Zweiges des Niederspannungsnetzes nach dem Auslösen der Sicherung durch ein Wiedereinschalten der Sicherung möglich. Ein hoher Strom muss demnach als Auslöser zum gezielten Ansprechen der Sicherung geleitet werden, wenn eine Ortung beispielsweise durch sukzessives An- und Abkoppeln einzelner Endverbraucher erfolgen soll. Jedenfalls ist absehbar, dass der Fehler zu einer erneuten Auslösung der Sicherung führen wird, so dass der Schaden langfristig beseitigt werden muss.

Zur Beseitigung eines derartigen Fehlers einer elektrischen Verbindung einer Muffe muss demnach zunächst die Muffe lokalisiert werden, die den Kabelfehler auslöst. Üblicherweise sind die Haupt- und Abzweigkabel im Boden verlegt, so dass ein einfaches, beispielsweise visuelles, Prüfen aller Muffen eines Hauptkabels nicht ohne erheblichen Aufwand möglich ist.

Bei bekannten Verfahren, um einen Kabelfehler, insbesondere einen Kurzschlussfehler, in einem Niederspannungsnetz im Boden zu orten, werden üblicherweise im Bereich der Sicherung des Hauptkabels sogenannte Stoßgeneratoren eingesetzt. Durch solche Stoßgeneratoren kann eine sehr hohe Spannung von mehreren 1000 Volt an ein Hauptkabel angelegt werden, um einen Kurzschluss an der Fehlerstelle zu generieren. Der Kurzschluss führt zu einem Lichtbogen, der sich auch durch ein akustisches Signal äußert. Ein solches akustisches Signal lässt sich durch ein Bodenmikrofon aufnehmen. Während gemäß dem bekannten Ortungsverfahren periodisch Kurzschlüsse mit dem Stoßgenerator erzeugt werden, werden die am Hauptkabel angeschlossenen Muffen nacheinander von einem Servicemitarbeiter mit dem Bodenmikrofon auf das akustische Signal hin überprüft. Der überprüfte Bereich, der ein akustisches Signal mit der vergleichsweise höchsten Amplitude liefert, zeigt demnach den Bereich der fehlerhaften Muffe an.

Problematisch bei dem genannten Verfahren ist jedoch, dass alle mit dem zu prüfenden Zweig verbundenen Endverbraucher zur Ausführung des bekannten Ortungsverfahrens vom Abzweigkabel getrennt werden müssen. Ohne Trennung besteht nämlich die Gefahr, dass elektrische Geräte der Endverbraucher durch die hohen periodischen Spannungen zum Erzeugen der Kurzschlüsse beschädigt werden. Eine Trennung der Endverbraucher erfordert üblicherweise eine Trennung am Anschluss des Endverbrauchers, wobei sich der Anschluss üblicherweise in nur privat zugänglichen Bereichen des Endverbrauchers, beispielsweis innerhalb eines Gebäudes des Endverbrauchers, befindet. Hierbei überschneiden sich häufig Abwesenheitszeiten der Endverbraucher, beispielsweise durch Berufsausübung, mit den Servicezeiten der Servicetechniker zum Beheben des Fehlers. Ein spontanes Trennen aller Anschlüsse der Endverbraucher eines Zweiges zur zeitnahen Fehlerbehebung ist daher zumindest teilweise durch fehlende Zugangsmöglichkeiten unpraktikabel. Ein solches Verfahren muss somit aufwändig geplant werden.

Darüber hinaus sind weitere Verfahren bekannt, bei denen beispielsweise eine Sicherung eines fehlerbehafteten Zweiges des Niederspannungsnetzes, die einer sogenannten Niederspannungs-Hochleistungs-Sicherung, kurz NH-Sicherung, entspricht, durch neuartige intelligente Sicherungen ersetzt werden. Solche intelligenten Sicherungen geben nach Art eines Lichtbogenreflektionsverfahrens nach dem Auftreten eines Fehlers eine ungefähre relative Position des Fehlers zur Sicherung aus. Bei diesem Verfahren wird eine geringere Spannung, vorzugsweise die übliche Versorgungsspannung von 400 Volt, benötigt, so dass die Endverbraucher nicht abgetrennt werden müssen.

Derartige intelligente Sicherungen ermöglichen dennoch nur eine Vorortung des Fehlers. Eine finale Lokalisierung oder Nachortung muss demnach häufig weiterhin mit einem Bodenmikrofon erfolgen, das manuell auf der Kabeltrasse geführt wird. Aufgrund der vergleichsweise geringen Spannung beim Vergleich mit dem zuerst beschriebenen Verfahren entstehen die Kurzschlüsse und entsprechend erfassbare Lichtbögen jedoch häufig erst, nachdem ein gewisser Zeitraum vergangen ist. Das Verfahren mit einer intelligenten Sicherung zur groben Vorortung mit Nachortung durch ein Bodenmikrofon kann somit eine unbestimmte Dauer von beispielsweise mehreren Stunden oder Tagen in Anspruch nehmen.

In der prioritätsbegründenden deutschen Patentanmeldung hat das Deutsche Patent- und Markenamt die folgenden Dokumente recherchiert: DE 10 2010 013 613 A1, DE 10 2010 026 815 A1, DE 10 2010 051 213 A1, DE 10 2021 124 670 B3, DE 10 2010 035 882 A1 und DE 10 2004 046 000 A1.

Aufgabe der vorliegenden Erfindung ist es daher, den Problemen des Standes der Technik zu begegnen. Insbesondere soll eine Ortung von Kabelfehlern in einem Niederspannungsnetz ermöglicht werden, bei der auf eine Trennung von Endverbrauchern verzichtet werden kann und bei der kein lang andauernder Einsatz von Servicepersonal nötig ist. Zumindest soll eine Alternative zum aus dem Stand der Technik Bekannten gefunden werden.

Hierzu schlägt die Erfindung eine Kabelfehlerortungsvorrichtung zur Ortung von Kabelfehlern in einem Niederspannungsnetz nach Anspruch 1 vor.

Erfindungsgemäß wird eine Kabelfehlerortungsvorrichtung zur Ortung von Kabelfehlern in einem Niederspannungsnetz vorgeschlagen. Die Kabelfehlerortungsvorrichtung umfasst einen Schallwandler, der insbesondere als mindestens ein Mikrofon oder Körperschallwandler ausgebildet ist. Der Schallwandler dient zum Aufnehmen von sich im Boden ausbreitendem Schall, also vorzugsweise Körperschall. Demnach ist die Kabelfehlerortungsvorrichtung oder zumindest der Schallwandler auch als Bodenmikrofon oder Körperschallmikrofon bezeichenbar. Vorzugsweise ist die Kabelfehlerortungsvorrichtung somit mit einem Kontaktbereich ausgebildet, der in Kontakt mit einem Boden oder Untergrund gebracht werden kann. Schall, der sich im Boden ausbreitet, kann so über den Kontaktbereich zum Schallaufnehmer gelangen. Gemäß einer Alternative kann dieser Kontaktbereich als ebene Fläche, in einem Boden oder Untergrund einbringbare Fläche oder als Spieß nach Art eines Bodenankers ausgebildet sein. Der Schallwandler dient demnach zum Aufnehmen von sich im Boden ausbreitenden Schall und zum Erzeugen eines elektrischen Signals in Abhängigkeit von dem aufgenommenen Schall.

Ferner umfasst die Kabelfehlerortungsvorrichtung eine Steuerung. Die Steuerung dient zum Erzeugen von Schallereignissen. Ein Schallereignis umfasst daher einen mit einem oder mehreren Zeitstempeln gekennzeichneten zeitlichen Verlauf eines mit dem Schallwandler erzeugten elektrischen Signals, vorzugsweise innerhalb eines vordefinierten Zeitfensters. Wird demnach mit dem Schallwandler ein sich im Boden ausbreitender Schall in ein elektrisches Signal gewandelt, so dient die Steuerung dazu, diesem elektrischen Signal einen oder mehrere Zeitstempel während eines Verlaufs zuzuordnen, wobei ein zeitlicher Verlauf des Signals, vorzugsweise innerhalb eines Zeitfensters, mit zugeordnetem Zeitstempel als Schallereignis bezeichnet wird.

Weiter umfasst die Steuerung eine Zeitbasis zum Bereitstellen des oder der Zeitstempel und eine Datenschnittstelle zur Kommunikation mit mindestens einer weiteren Kabelfehlerortungsvorrichtung. Die Datenschnittstelle ist vorzugsweise als Drahtlosschnittstelle ausgebildet oder umfasst eine Drahtlosschnittstelle. Die Datenschnittstelle kann auch als Funkschnittstelle bezeichnet werden. Die Steuerung ist eingerichtet, um unter Verwendung der Datenschnittstelle, also durch Kommunikation mit mindestens einer weiteren Kabelfehlerortungsvorrichtung, die Zeitbasis mit der Zeitbasis mindestens einer weiteren Kabelfehlerortungsvorrichtung, vorzugsweise drahtlos, also über eine Funkverbindung, zu synchronisieren.

Durch die Fähigkeit der Kabelfehlerortungsvorrichtung, sich über eine Datenschnittstelle mit einer weiteren Kabelfehlerortungsvorrichtung zu synchronisieren, nämlich die Zeitbasen der beiden Kabelfehlerortungsvorrichtungen zu synchronisieren, können Schallereignissen Zeitstempel zugeordnet werden, um die Schallereignisse zeitlich vergleichbar zu machen. Laufzeitunterschiede des sich aus einer Schallquelle ausbreitenden Schalls können somit ermittelt und durch ermittelte Laufzeitunterschiede des Schalls eine relative Position der Schallquelle bestimmt werden.

Fehler in einem Niederspannungsnetz können somit durch den Einsatz der erfindungsgemäßen Kabelfehlerortungsvorrichtung, insbesondere in Gruppen von mehreren Kabelfehlerortungsvorrichtungen, ohne das Umpositionieren einer einzelnen Kabelfehlerortungsvorrichtung geortet werden, indem mehrere synchronisierte Kabelfehlerortungsvorrichtungen verwendet werden. Einsatz von Personal zum Umpositionieren der Kabelfehlerortungsvorrichtung wird somit nicht benötigt. Außerdem genügt ein einziges Schallereignis zur Ortung von Kabelfehlern, so dass außerdem eine benötigte Einsatzzeit für die Ortung von Kabelfehlern signifikant reduziert wird. Durch Kennzeichnung der Schallereignisse mit synchronisierten Zeitstempeln ist außerdem eine Beobachtung des betreffenden Zweiges des Niederspannungsnetzes durch einen Servicemitarbeiter vor Ort bis zum Eintreten des Schallereignisses unnötig. Die Ortung kann selbständig ohne Überwachung durchgeführt werden.

Eine Ausbildung der Datenschnittstelle als Drahtlosschnittstelle ermöglicht eine besonders sichere und individuelle Platzierung mehrere Kabelfehlerortungsvorrichtungen. Eine Personen- oder Fahrzeugverkehr behindernde Kabelverlegung zur Zeitbasensynchronisation wird vermieden. Hindernisse, die eine Kabelverlegung erschweren, können unbeachtet bleiben.

Gemäß einer ersten Ausführungsform umfasst die Kabelfehlerortungsvorrichtung einen Strahlungssensor zum Erkennen von vordefinierten elektromagnetischen Impulsen. Der Strahlungssensor dient zum Wandeln eines erkannten Impulses in ein elektrisches Auslösesignal. Gemäß dieser Ausführungsform ist die Steuerung ferner eingerichtet, ein Schallereignis für ein vordefiniertes Zeitfenster, also eine vordefinierte Zeitdauer, nach dem Erkennen eines elektromagnetischen Impulses zu erzeugen. Wird demnach ein vordefinierter elektromagnetischer Impuls mit dem Strahlungssensor aufgenommen, der einem vordefinierten Impuls entspricht, also bestimmte vordefinierte Parameter aufweist, wird dieser als erkannt gewertet. Ein vordefinierter Parameter ist vorzugsweise als ein Amplitudenwert des Impulses definiert, der oberhalb eines Schwellwertes liegt und/oder innerhalb eines vordefinierten Zeitbereiches auftaucht und wieder abklingt.

Diesem Ausführungsbeispiel liegt die Kenntnis zugrunde, dass durch einen Fehler im Zweig eines Niederspannungsnetzes, der als Kurzschlussfehler ausgebildet ist, ein Lichtbogen entsteht, der zu einer kurzzeitigen breitbandigen elektromagnetischen Strahlung, also einem Impuls, führt. Der elektromagnetische Impuls, der hierdurch entsteht, breitet sich annähernd mit Lichtgeschwindigkeit durch den Boden aus und kann somit als Auslöser oder Trigger für die Steuerung dienen, indem er ein Auslösesignal erzeugt. Mit dem Auslösesignal wird dann rechtzeitig der Schallwandler aktiviert, so dass die sich vergleichsweise langsamer ausbreitende Schall- oder Druckwelle an der Kabelfehlerortungsvorrichtung aufgenommen werden kann. Eine Schallmessung, also ein Betreiben der Schallaufnehmer, muss somit nicht dauerhaft ausgeführt werden. Die Kabelfehlerortungsvorrichtung kann in einem Ruhemodus verbleiben, bis sie durch den Strahlungssensor aktiviert wird, um die elektrischen Signale in Abhängigkeit vom aufgenommenen Schall zu erzeugen. Eine Reduzierung der aufzuwendenden Energie zum Betrieb der Kabelfehlerortungsvorrichtung wird gegenüber einem Dauerbetrieb ermöglicht.

Gemäß einer weiteren Ausführungsform ist die Steuerung eingerichtet, ein Schallereignis zu speichern. Die Kabelfehlerortungsvorrichtung weist dementsprechend einen Speicher auf. Der Speicher ist vorzugsweise so ausgebildet, dass dieser mehrere Schallereignisse speichern kann. Die gespeicherten Schallereignisse sind beispielsweise über ein Datenkabel aus dem Speicher auslesbar. Die Kabelfehlerortungsvorrichtung weist dazu beispielsweise einen Steckverbinder zum Herstellen einer Datenverbindung auf.

Gemäß einer weiteren Ausführungsform ist die Steuerung eingerichtet, ein Schallereignis über die Datenschnittstelle an eine Auswerteeinrichtung, vorzugsweise drahtlos, zu übertragen. Vorzugsweise wird das Schallereignis unmittelbar nach dem Erkennen an die Auswerteeinrichtung übertragen. Im Fall, dass ein Speicher vorgesehen ist, können ein oder mehrere Schallereignisse alternativ in dem Speicher zwischengespeichert und an vordefinierten Zeitpunkten oder durch Aufforderung oder nach Abruf an die Auswerteeinrichtung übertragen werden.

Gemäß einer weiteren Ausführungsform ist die Steuerung eingerichtet, ein Schallereignis an einer weiteren Kabelfehlerortungsvorrichtung, insbesondere über eine Datenschnittstelle, vorzugsweise zur Weiterleitung an die Auswerteeinrichtung oder zur Speicherung in der weiteren Kabelfehlerortungsvorrichtung zu übertragen. Vorzugsweise ist es so möglich, dass nur eine Steuerung einer Kabelfehlerortungsvorrichtung von mehreren Kabelfehlerortungsvorrichtungen eingerichtet ist, Schallereignisse an die Auswerteeinrichtung zu übertragen oder zu speichern. Die übrigen Kabelfehlerortungsvorrichtungen können erzeugte Schallereignisse so einer bestimmten Kabelfehlerortungsvorrichtung zur Weiterleitung senden. Kosten für eine Ausbildung einer Datenschnittstelle zur Kommunikation mit einer Auswerteeinheit oder für einen Speicher können so durch Konzentration auf eine einzelne Kabelfehlerortungsvorrichtung mit dieser Ausstattung reduziert werden.

Gemäß einer weiteren Ausführungsform umfasst die Kabelfehlerortungsvorrichtung eine Schrittspannungsmesseinrichtung zur Messung einer Schrittspannung. Die Schrittspannungsmesseinrichtung umfasst mindestens ein Paar von zwei Elektroden die eingerichtet sind, einen Boden zu kontaktieren. Die Elektroden, die Erdkontakten oder Erdspießen aus einem leitenden Material entsprechen, sind demnach vorzugsweise auf einer Unterseite eines Gehäuses der Kabelfehlerortungsvorrichtung, beabstandet, beispielsweise an gegenüberliegenden Randbereichen des Gehäuses, zueinander angeordnet. Das Gehäuse hat vorzugsweise auf der Außenseite Markierungen, die die Position der Elektroden angeben und einem Benutzer der Kabelfehlerortungsvorrichtung so ermöglichen, die Elektroden auszurichten.

Gemäß einer bevorzugten Ausführungsform umfasst die Schrittspannungsmesseinrichtung zwei Paare von Elektroden. Gemäß einer weiteren bevorzugten Ausführungsform sind die Elektroden der beiden Paare so angeordnet, dass eine Verbindungslinie der Elektroden eines Paares im Wesentlichen senkrecht zu einer Verbindungslinie der Elektroden des anderen Paares verläuft. Auch hier können Markierungen vorgesehen sein, so dass ein Benutzer die Kabelfehlerortungsvorrichtung so positionieren kann, dass die Elektroden des einen Paares in Verlaufsrichtung einer zu prüfenden elektrischen Leitung und die Elektroden des anderen Paares quer zur Verlaufsrichtung anordenbar sind.

Die Elektroden der Schrittspannungsmesseinrichtung sind mit der Steuerung verbunden. Die Steuerung ist eingerichtet, eine Spannung zwischen den Elektroden eines Paares oder im Fall mehrerer Paare jeweils eine Spannung zwischen den Elektroden jedes der Paare zu bestimmen. Die Steuerung ist außerdem eingerichtet, einen Spannungsverlauf der bestimmten Spannung oder Spannungsverläufe der bestimmten Spannungen zu ermitteln und aufzuzeichnen oder während eines Zeitfensters eines Schallereignisses im Schallereignis darzustellen.

Eine Schrittspannung kann somit ebenfalls betrachtet und zur Lokalisierung eines Fehlers ausgewertet werden.

Fließt durch ein Erdkabel ein Strom, tritt dieser möglicherweise bei einem Kabelfehler mit einem Erdschluss an der Stelle des Erdschlusses in das umgebende Erdreich aus und fließt an dieser nach allen Seiten ab. Eine Spannung fällt von der Stelle aus mit wachsender Entfernung ab. Wird nun an der Erdoberfläche über dem Kabel mit der Schrittspannungsmesseinrichtung eine Spannung, nämlich die Schrittspannung, gemessen, also die Spannungsdifferenz zwischen den zwei das Erdreich kontaktierenden Elektroden der Schrittspannungsmesseinrichtung, so lässt sich aus dem Betrag der gemessenen Spannung auf den Abstand zum Erdschluss schließen.

Gemäß einer weiteren Ausführungsform ist die Kabelfehlerortungsvorrichtung entweder vom Typ eines Masters oder vom Typ eines Slaves. Im Fall, dass die Kabelfehlerortungsvorrichtung vom Typ eines Masters ist, also einem Master entspricht, ist die Datenschnittstelle zur Kommunikation über ein erstes Kommunikationsprotokoll und ein zweites Kommunikationsprotokoll eingerichtet. Das erste Kommunikationsprotokoll dient zum Kommunizieren mit einer oder mehreren weiteren Kabelfehlerortungsvorrichtungen, insbesondere zum Synchronisieren der Zeitbasis und zum Senden und Empfangen von Schallereignissen, Das zweite Kommunikationsprotokoll dient zum Datenaustausch mit der Auswerteeinrichtung. Ist die Kabelfehlerortungsvorrichtung vom Typ eines Slaves, entspricht also einem Slave, so weist die Kabelfehlerortungsvorrichtung eine Datenschnittstelle auf, die nur zum Datenaustausch über das erste Kommunikationsprotokoll eingerichtet ist. Unterschiedliche Kommunikationsprotokolle sind vorteilhaft, da so einerseits eine zeitkritische Kommunikation zwischen den Kabelfehlerortungsvorrichtungen und andererseits eine reichweitenoptimierte Kommunikation mit einer Auswerteeinheit möglich ist. Um eine Ortung von Kabelfehlern gemäß dieser Ausführungsform ausführen zu können, werden demnach in einem System nur ein Master und mehrere Slaves benötigt, wobei die volle Funktion der Ortung von Kabelfehlern bereitsteht und Kosten für die Datenschnittstellen der Slaves reduziert werden können. Insbesondere kann so auch ein Energieaufwand zum Betreiben des Gesamtsystems reduziert werden.

Gemäß einer weiteren Ausführungsform weist die Datenschnittstelle eine WPAN-Schnittstelle (Wireless Personal Area Network-Schnittstelle), insbesondere ZigBee-Schnittstelle, zur Realisierung des ersten Kommunikationsprotokolls und/oder eine GSM- oder UMTS-Schnittstelle zur Realisierung des zweiten Kommunikationsprotokolls auf.

Standardisierte Bauteile sind so für die Realisierung der Datenschnittstelle der Kabelfehlerortungsvorrichtung einsetzbar, die günstig verfügbar sind und zusätzlich energieoptimiert bzw. reichweitenoptimiert arbeiten, um die benötigten Funktionen beim Betrieb der Kabelfehlerortungsvorrichtung zu ermöglichen.

Gemäß einer weiteren Ausführungsform umfasst die Kabelfehlerortungsvorrichtung eine Diebstahlsicherung. Die Diebstahlsicherung umfasst eine elektronische Diebstahlsicherung mit einem Beschleunigungssensor, um einen Diebstahl zu erkennen, wenn bei aktivierter Diebstahlsicherung die Kabelfehlerortungsvorrichtung bewegt wird. Außerdem umfasst die Kabelfehlerortungsvorrichtung einen Lautsprecher und/oder ein Leuchtsignal, das bei Auslösen der Diebstahlsicherung aktivierbar ist, um den erkannten Diebstahl anzuzeigen.

Gemäß einer Alternative oder zusätzlich umfasst die elektronische Diebstahlsicherung eine Positionsermittlungseinheit, die beispielsweise einen GPS-Empfänger zum Bestimmen einer Position umfasst. Insbesondere über die Datenschnittstelle, beispielsweise mit dem zweiten Kommunikationsprotokoll, kann in regelmäßigen Abständen oder im Fall eines erkannten Diebstahls die aktuelle Position an die Auswerteeinrichtung oder eine weitere Einrichtung zum Wiederauffinden der Kabelfehlerortungsvorrichtung übertragen werden.

Alternativ oder zusätzlich zur elektronischen Diebstahlsicherung umfasst die Diebstahlsicherung gemäß einer weiteren Ausführungsform einen Bodenanker. Der Bodenanker ist im Boden elektronisch oder manuell verankerbar oder einrastbar. Ein elektronisches Verankern oder Einrasten kann beispielsweise über die Datenschnittstelle aktiviert werden. Ein manuelles Einrasten oder Verankern ist beispielsweise mit einem Schloss möglich. Durch den Bodenanker wird somit ein Lösen des Bodenankers nur mit einem passenden Schlüssel oder mit Zugang zur Datenschnittstelle möglich.

Gemäß einer weiteren Ausführungsform umfasst die Kabelfehlerortungsvorrichtung einen Energiespeicher, der vorzugsweise als Akkumulator ausgebildet ist. Die Steuerung, die Kabelfehlerortungsvorrichtung sowie die Datenschnittstelle sind vorzugsweise durch die entsprechende Kapazität des Energiespeichers über mindestens 24 Stunden mit dem Energiespeicher betreibbar. Vorzugsweise ist ein Solarmodul zum Aufladen des Energiespeichers Bestandteil der Kabelfehlerortungsvorrichtung. Die Kabelfehlerortungsvorrichtung kann so zumindest für einen einzelnen Einsatz vollständig autark betrieben werden.

Gemäß einer weiteren Ausführungsform umfasst die Kabelfehlerortungsvorrichtung ein Gehäuse, das vorzugsweise nach Art einer Pylone ausgebildet ist. Weiter bevorzugt kann das Gehäuse halbkugelförmig ausgebildet sein, indem es beispielsweise die Form eines Schildkrötenpanzers aufweist. Vorzugsweise ist das Gehäuse mit einer Signalfarbe, beispielsweise einer Leuchtfarbe, wie einer Neonfarbe, gekennzeichnet. Das Wetterschutzgehäuse ist ausgebildet, um die Komponenten, insbesondere den Schallwandler und die Steuerung sowie die Datenschnittstelle vor Wettereinflüssen, wie Feuchtigkeit und/oder Schmutz, zu schützen. Vorzugsweise ist das Gehäuse auch ausgebildet, um Schall, der sich nicht im Boden ausbreitet, vom Schallwandler abzuhalten oder zu reduzieren. Das Gehäuse weist demnach vorzugsweise einen allseitigen Schallschutz ausgenommen von dem Bereich auf, in dem der Schallwandler angeordnet ist.

Neben einem Wetterschutz dient das Gehäuse somit auch zur Kennzeichnung, insbesondere für den Fall, dass die Kabelfehlerortungsvorrichtung im Bereich eines Geh- oder Fahrradwegs aufgestellt wird.

Ferner umfasst die Erfindung ein System mit mindestens zwei Kabelfehlerortungsvorrichtungen gemäß einer der vorgenannten Ausführungsformen. Vorzugsweise umfasst das System drei derartige Kabelfehlerortungsvorrichtungen.

Gemäß einer Ausführungsform des Systems umfasst das System zusätzlich eine Auswerteeinheit zum Auswerten der Schallereignisse. Die Auswerteeinheit dient beispielsweise zum Erzeugen eines Indikators für eine Ortung von Kabelfehlern in Abhängigkeit von Schallereignissen unterschiedlicher Kabelfehlerortungsvorrichtungen. Etwa durch Autokorrelation der zeitlichen Verläufe der elektrischen Signale ist als Indikator ein Abstand der Schallquelle, die dem Fehlerort entspricht, zu einem oder mehreren der Kabelfehlerortungsvorrichtungen bestimmbar.

Gemäß einer weiteren Ausführungsform umfasst das System genau einen Schallaufnehmer, der als Master ausgebildet ist, und mindestens einen oder mindestens zwei Schallaufnehmer, die als Slave ausgebildet sind.

Gemäß einer weiteren Ausführungsform des Systems umfasst das System ein NH-Sicherungssystem umfassend eine NH-Sicherung, nämlich eine Niederspannungs-Hochleistungs-Sicherung, und eine Datenschnittstelle. Die NH-Sicherung ist mit einem auf einen Fehler zu prüfenden Hauptkabel eines Zweiges eines Niederspannungsnetzes verbindbar und umfasst ferner eine Steuerung zum Erkennen eines Kurzschlusses. Im Fall eines erkannten Kurzschlusses ist das Sicherungssystem eingerichtet, um ein Auslösesignal an mindestens eine Kabelfehlerortungsvorrichtung oder alle Kabelfehlerortungsvorrichtungen zu übertragen, um eine Erzeugung von Schallereignissen auszuführen. Alternativ oder zusätzlich zu einem Strahlungssensor kann so sicher ein von einem Kurzschluss herrührendes Schallereignis erkannt werden, wobei die Gefahr einer Erzeugung von Schallereignissen durch Umgebungsgeräusche oder elektromagnetische Impulse, die nicht vom Fehler des Hauptkabels stammen, reduziert wird.

Außerdem betrifft die Erfindung ein Verfahren zur Ortung von Kabelfehlern in einem Niederspannungsnetz. Das Verfahren umfasst das Betreiben eines Systems nach einer der vorgenannten Ausführungsformen.

Gemäß einer Ausführungsform des Verfahrens umfasst das Verfahren das Synchronisieren von Zeitbasen von Steuerungen der Kabelfehlerortungsvorrichtungen über eine Datenschnittstelle der Steuerung, die vorzugsweise als Drahtlosschnittstelle oder Funkschnittstelle ausgebildet ist.

Gemäß einer weiteren Ausführungsform des Verfahrens werden mit den Schallwandlern der jeweiligen Kabelfehlerortungsvorrichtungen kontinuierlich sich im Boden ausbreitende Schallsignale in elektrische Signale umgewandelt. Die Steuerung einer jeweiligen Kabelfehlerortungsvorrichtung erfasst ein Schallereignis, wenn ein elektrisches Signal des jeweiligen Schallaufnehmers einen für einen Kurzschluss charakteristischen Verlauf aufweist, insbesondere wenn das elektrische Signal oberhalb von einer Amplitude liegt oder verläuft. Die Steuerung erfasst dann das Schallereignis als Verlauf des elektrischen Signals in einem Zeitfenster, beginnend vor dem elektrischen Signal oberhalb der vordefinierten Amplitude und endend nach Abklingen der Amplitude. Dem Zeitfenster des elektrischen Signals werden ein oder mehrere Zeitstempel zugeordnet.

Gemäß einer weiteren Ausführungsform ist der oder jeder der Schallwandler in einem Ruhemodus deaktiviert, bis mit einem Strahlungssensor ein vordefinierter elektromagnetischer Impuls oder mit einem NH-Sicherungssystem ein Kurzschluss erkannt und ein entsprechendes Auslösesignal erhalten wird. Daraufhin wird der Schallwandler für eine vordefinierte Zeitdauer aktiviert und das resultierende elektrische Signal mit der Steuerung als Schallereignis aufgezeichnet. Dem Verlauf werden ein oder mehrere Zeitstempel zugeordnet.

Gemäß einer weiteren Ausführungsform werden Schallereignisse in der Auswerteeinheit gespeichert. Alternativ oder zusätzlich werden Schallereignisse an die Auswerteeinrichtung über die Datenschnittstelle von jeder der Kabelfehlerortungsvorrichtungen übertragen. Alternativ oder zusätzlich werden Schallereignisse aller Kabelfehlerortungsvorrichtungen eines Systems, die als Slave ausgebildet sind, über die jeweiligen Datenschnittstellen an eine Kabelfehlerortungsvorrichtung, die als Master ausgebildet ist, übertragen. Der als Master ausgebildete Schallaufnehmer überträgt dann die Schallereignisse an eine Auswerteeinheit.

Weitere Ausführungsformen ergeben sich anhand der in den Figuren näher erläuterten Ausführungsbeispiele. Hierbei zeigen:
- Fig. 1: ein Ausführungsbeispiel einer Kabelfehlerortungsvorrichtung,
- Fig. 2: ein Ausführungsbeispiel eines Systems mit mehreren Kabelfehlerortungsvorrichtungen,
- Fig. 3: ein Verfahren gemäß einem ersten Ausführungsbeispiel und
- Fig. 4: ein Verfahren gemäß einem zweiten Ausführungsbeispiel.

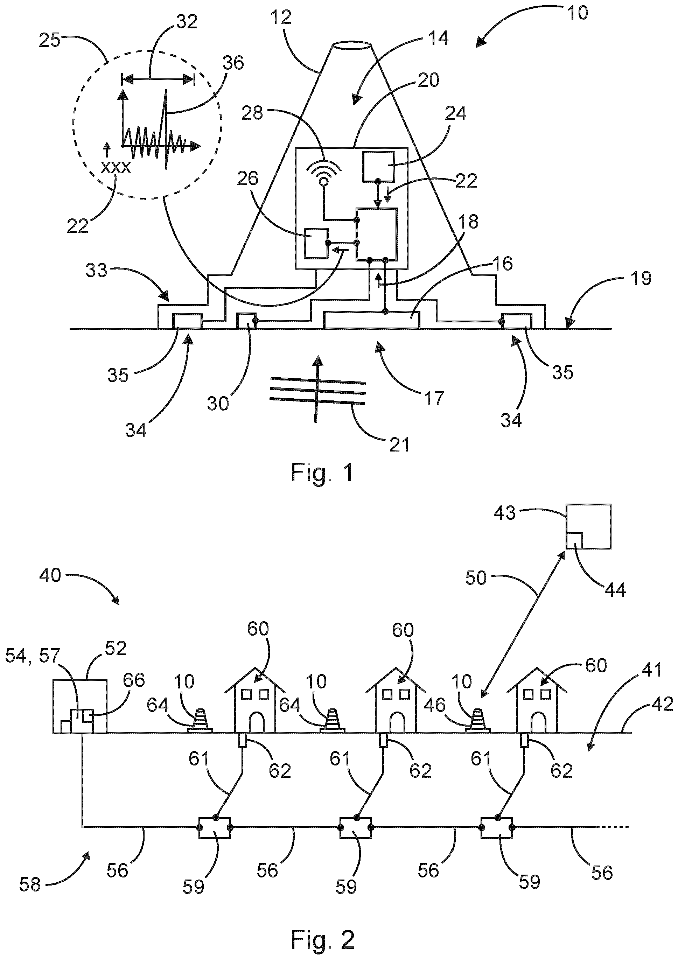

Fig. 1 zeigt eine Kabelfehlerortungsvorrichtung 10 mit einem Gehäuse 12 in einer schematischen Schnittdarstellung, um Komponenten 14 der Kabelfehlerortungsvorrichtung 10 im Gehäuse 12 sichtbar zu machen. Die Kabelfehlerortungsvorrichtung 10 umfasst einen Schallwandler 16, der auf der Unterseite 17 der Kabelfehlerortungsvorrichtung 10 angeordnet ist, um bei einsatzgemäßer Aufstellung der Kabelfehlerortungsvorrichtung 10 sich im Boden 19 ausbreitenden Schall 21 aufzunehmen und in elektrische Signale 18 zu wandeln. Die elektrischen Signale 18 werden einer Steuerung 20 zugeführt. Die Steuerung 20 ist eingerichtet, die elektrischen Signale 18 mit Zeitstempeln 22 einer Zeitbasis 24 der Steuerung 20 zu kennzeichnen und als Schallereignis 25 in einem Speicher 26 zu speichern.

Alternativ oder zusätzlich zum Speichern können Schallereignisse 25 über eine Datenschnittstelle 28, die als Drahtlosschnittstelle ausgebildet ist und auch als Funkschnittstelle bezeichnet werden kann, ausgesendet werden. Die Steuerung 20 ist ferner eingerichtet, die Zeitbasis 24 über die Datenschnittstelle 28 mit den Zeitbasen 24 weiterer Kabelfehlerortungsvorrichtungen 10 synchronisieren.

Zudem umfasst die Kabelfehlerortungsvorrichtung 10 einen Strahlungssensor 30, um elektromagnetische Impulse zu erkennen. Vorzugsweise ist die Steuerung 20 eingerichtet, um im Fall eines vordefinierten elektromagnetischen Impulses, der mit dem Strahlungssensor 30 erkannt wird, ein Schallereignis 25 aufzunehmen. Demnach wird nach dem Erkennen des Impulses eine Aufzeichnung des elektrischen Signals 18, das vom Schallwandler 16 empfangen wird, für eine vordefinierte Zeitdauer, insbesondere ein Zeitfenster 32, aufgenommen und mit einem oder mehreren Zeitstempeln 22 versehen. Ein Schallereignis 25 umfasst dann einen zeitlichen Verlauf 36 des elektrischen Signals 18 für ein vordefiniertes Zeitfenster 32. Beispielsweise wird ein Start- und ein Endpunkt des Zeitfensters, nur ein Startpunkt des Zeitfensters oder der Verlauf des elektrischen Signals des gesamten Zeitfensters in Intervallen mit Zeitstempeln 22 versehen, um ein Schallereignis 25 zu bilden.

Zudem umfasst die Kabelfehlerortungsvorrichtung 10 eine Schrittspannungsmesseinrichtung 33. Die Schrittspannungsmesseinrichtung 33 umfasst zwei Paare 34 mit jeweils zwei Elektroden 35 die eingerichtet sind einen Boden 19 zu kontaktieren. In Fig. 1 sind aufgrund der Schnittdarstellung nur zwei Elektroden 35 eines ersten Paares 34 dargestellt. Die Elektroden 35 sind mit der Steuerung verbunden, um jeweils eine Spannung zwischen den Elektroden 35 jedes der beiden Paare 34 zu bestimmen. Die Steuerung 20 ist außerdem eingerichtet, Spannungsverläufe der beiden Spannungen während eines Zeitfensters 32 eines Schallereignisses 25 im Schallereignis 25 darzustellen.

Fig. 2 zeigt ein System 40, das mehrere Kabelfehlerortungsvorrichtungen 10 umfasst. Die Kabelfehlerortungsvorrichtungen 10 sind auf einer Oberfläche 42, z. B. einem Gehweg, angeordnet. Demnach zeigt Fig. 2, die wiederum einer schematischen Darstellung entspricht, unterhalb der Oberfläche 42 einen Untergrund 41, der auch als Boden bezeichnet werden kann, unter dem Gehweg. Das System 40 umfasst ferner eine Auswerteeinheit 43, die über eine Datenschnittstelle 44 der Auswerteeinheit 43 mit einer Datenschnittstelle 28 einer als Master 46 ausgebildeten Kabelfehlerortungsvorrichtung 10 verbunden ist. Die Verbindung der Datenschnittstellen 44, 28 ist beispielsweise eine GPRS-Verbindung 50. Die Kabelfehlerortungsvorrichtungen 10 sind ferner untereinander mit ihren Datenschnittstellen 28 verbunden, um Daten auszutauschen.

Zudem ist in Fig. 2 ein Sicherungskasten 52 dargestellt, in dem über eine Sicherung 54 ein Hauptkabel 56 abgesichert ist. Das Hauptkabel 56 ist Teil eines Niederspannungsnetzes 58. An das Hauptkabel 56 sind über Muffen 59 Abzweigkabel 61 angeschlossen, die zu Endverbrauchern in deren Wohnungen 60 führen, um diese mit elektrischer Energie zu versorgen. Die Abzweigkabel 61 führen demnach jeweils bis zu einem Hausanschluss 62.

Tritt ein Fehler in einer der Muffen 59 auf, so kann im Fall eines als Kurzschluss ausgebildeten Fehlers über einen Laufzeitunterschied eines Schalls, der sich von der defekten oder fehlerhaften Muffe 59 anhand des Kurzschlusses ausbreitet, eine Ortung von Kabelfehlern erfolgen. Hierzu werden Schallereignisse 25 erzeugt, indem der den Kurzschluss repräsentierende Schall 21 in Form eines zeitlichen Verlaufs eines elektrischen Signals 18 in jeder der Kabelfehlerortungsvorrichtungen 10 mit Zeitstempeln versehen wird.

Ein Schallereignis 25, das von einer als Slave 64 ausgebildeten Kabelfehlerortungsvorrichtung 10 erzeugt wird, wird an die als Master 46 ausgebildete Kabelfehlerortungsvorrichtung 10 übertragen. Die als Master 46 ausgebildete Kabelfehlerortungsvorrichtung 10 überträgt dann die zu einem Kurzschluss gehörenden Schallereignisse 25 an die Auswerteeinheit 43. Beispielsweise durch Autokorrelation der elektrischen Signale der Schallereignisse lässt sich bei im wesentlichen bekannter Verlegetiefe und bekanntem Verlauf des Hauptkabels 56 eine Fehlerposition bestimmen.

Die Erfindung betrifft gemäß einem weiteren Ausführungsbeispiel, das in Fig. 2 zusätzlich dargestellt ist, um die Erfindung weiterzubilden, eine als intelligente Sicherung 57 ausgebildete Sicherung 54. Diese intelligente Sicherung 57 kann zusätzlich oder alternativ, wenn Kabelfehlerortungsvorrichtungen 10 ohne Strahlungssensor 30 ausgebildet sind, einen Kurzschluss in dem Hauptkabel 56 detektieren und über eine Datenschnittstelle 66 der intelligenten Sicherung 57 den Steuerungen 20 der Kabelfehlerortungsvorrichtungen 10 ein Auslösesignal zum Aufzeichnen eines Schallereignisses senden.

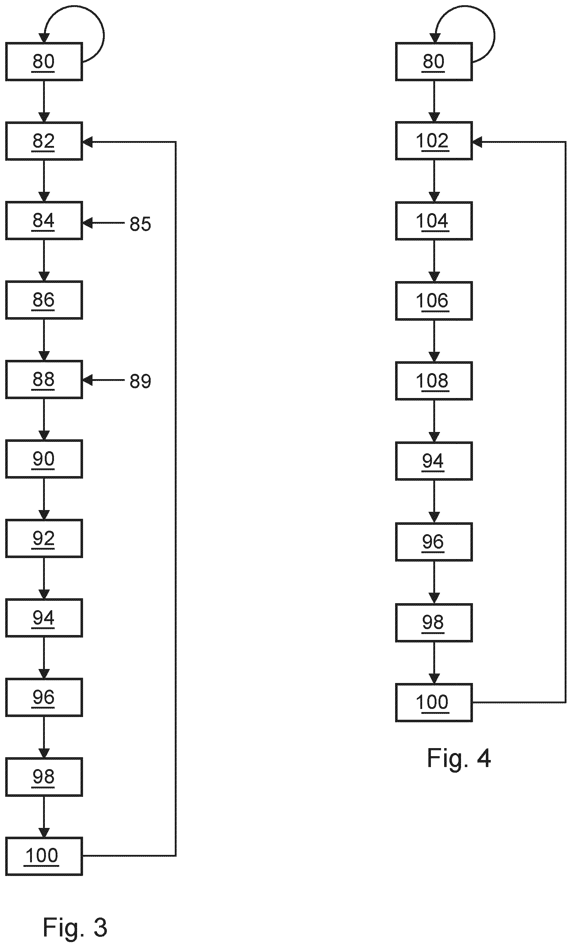

Fig. 3 zeigt ein Verfahren gemäß einem ersten Ausführungsbeispiel. In einem Schritt 80 werden Zeitbasen 24 mehrerer Kabelfehlerortungsvorrichtungen 10 eines Systems 40 miteinander synchronisiert. Dieser Schritt wird während des gesamten Verfahrens kontinuierlich, beispielsweise im zeitlichen Abstand von einer Sekunde oder mehreren Millisekunden wiederholt.

Im Schritt 82 wartet jede der Kabelfehlerortungsvorrichtungen 1 0 jeweils auf ein Auslöseereignis, wobei die entsprechenden Schallwandler 16 deaktiviert sind. Im Schritt 84 wird in jedem der Schallwandler 10 des Systems 40 ein Auslöseereignis 85 von einem Strahlungssensor 30 der Kabelfehlerortungsvorrichtung 10 erzeugt und von einer Steuerung 20 der Kabelfehlerortungsvorrichtung 10 empfangen, so dass im Schritt 86 die Schallwandler 10 jeder der Schallwandlereinheiten 10 aktiviert werden, um sich im Boden ausbreitenden Schall 21, der auf die entsprechenden Schallaufnehmer 16 trifft, in elektrische Signale 18 umzuwandeln.

Im Schritt 88 wird das Wandeln des Schalls in elektrische Signale fortgesetzt, bis eine vordefinierte Zeitdauer 89 abgelaufen ist. Die Zeitdauer 89 definiert vorzugsweise ein Zeitfenster 32. Daraufhin werden im Schritt 90 die Schallwandler 16 deaktiviert. Der zeitliche Verlauf 36 des elektrischen Signals 18 wird im Schritt 92 in jeder der Schallwandlereinheiten 10 mit einem oder mehreren Zeitstempeln 22 der jeweiligen Zeitbasis 28, beispielsweise dem Zeitpunkt des Starts im Schritt 86, als Schallereignis 25 markiert.

Im Schritt 94 werden die Schallereignisse 25 von allen Kabelfehlerortungsvorrichtungen 10, die als Slave 64 ausgebildet sind, an eine Kabelfehlerortungsvorrichtung 10, die als Master 46 ausgebildet ist, übertragen. Im Schritt 96 werden von der Kabelfehlerortungsvorrichtung 10, die als Master 46 ausgebildet ist, die gesammelten Schallereignisse 25 an eine Auswerteeinheit 43 übertragen. In Schritt 98 werden die Schallereignisse 25 ausgewertet und eine relative Distanz zu einer bestimmten oder mehreren Kabelfehlerortungsvorrichtungen 10 durch Laufzeitunterschiede des Schalls 21 bestimmt. In Schritt 100 werden Schallereignisse 25 und/oder zur Ortung von Kabelfehlern dienende Parameter, wie beispielsweise die zuvor genannte Distanz, dargestellt.

In Fig. 4 ist ein weiteres Ausführungsbeispiel eines Verfahrens zur Ortung von Kabelfehlern in einem Niederspannungsnetz 58 gezeigt. Wie im in Fig. 3 dargestellten Ausführungsbeispiel wird Schritt 80 ausgeführt, bei dem die Zeitbasen 24 mehrerer Kabelfehlerortungsvorrichtungen 10 synchronisiert werden. Dieser Schritt 80 wird auch hier während des gesamten Verfahrens kontinuierlich wiederholt.

In Schritt 102 wird kontinuierlich mit den Schallwandlern 16 der Kabelfehlerortungsvorrichtungen 10 eines Systems 40 ein sich im Boden ausbreitender Schall 21, der auf die Schallwandler 16 trifft, in elektrische Signale 18 umgewandelt. Im Schritt 104 wird eine Amplitude des elektrischen Signals 18, das auf einen Fehler im Niederspannungsnetz 58, nämlich insbesondere auf einen Kurzschluss hinweist, erfasst. Vorzugsweise wird die Amplitude des elektrischen Signals 18 überwacht und das elektrische Signal 18 als auf einen Fehler im Niederspannungsnetz 58 hindeutend erkannt, wenn das elektrische Signal 18 oberhalb eines vordefinierten Schwellenwerts liegt. Ist ein solcher Verlauf des elektrischen Signals 18 erkannt, wird im Schritt 106 weiterhin das elektrische Signal 18 aus dem auf den Schallwandler 16 eintreffenden Schall 21 erzeugt. Im Schritt 108 wird jedoch ein Schallereignis 25 durch ein Zeitfenster 32 des elektrischen Signals 18 gebildet, das zu einem vordefinierten Zeitpunkt vor dem erfassten elektrischen Signal 18, das auf den Fehler hindeutet, beginnt und das nach einem vordefinierten Zeitpunkt nach dem erfassten elektrischen Signal 18, das auf den Fehler hindeutet, endet. Das Zeitfenster 32 wird zudem im Schritt 108 mit Zeitstempeln 24 versehen. Darauf folgen die Schritte 94 bis 100 analog zur Fig. 3.

### Bezugszeichenliste

- 10: Kabelfehlerortungsvorrichtung
- 12: Gehäuse
- 14: Komponenten
- 16: Schallwandler
- 17: Unterseite
- 18: Signale
- 19: Boden
- 20: Steuerung
- 21: Schall
- 22: Zeitstempel
- 24: Zeitbasis
- 25: Schallereignis
- 26: Speicher
- 28: Datenschnittstelle
- 30: Strahlungssensor
- 32: Zeitfenster
- 33: Schrittspannungsmesseinrichtung
- 34: Paar
- 35: Elektroden
- 36: zeitlicher Verlauf
- 40: System
- 41: Untergrund
- 42: Oberfläche
- 43: Auswerteeinheit
- 44: Datenschnittstelle
- 46: Master
- 48: Datenverbindung
- 50: GPRS-Verbindung
- 52: Sicherungskasten
- 54: Sicherung
- 56: Hauptkabel
- 57: intelligente Sicherung
- 58: Niederspannungsnetz
- 59: Muffen
- 60: Wohnungen
- 61: Abzweigkabel
- 62: Hausanschluss
- 64: Slave
- 66: Datenschnittstelle
- 80: Schritt
- 82: Schritt
- 84: Schritt
- 86: Schritt
- 88: Schritt
- 89: Zeitdauer
- 90: Schritt
- 92: Schritt
- 94: Schritt
- 96: Schritt
- 98: Schritt
- 100: Schritt
- 102: Schritt
- 104: Schritt
- 106: Schritt
- 108: Schritt

## Patentansprüche

1. Kabelfehlerortungsvorrichtung (10) zur Ortung von Kabelfehlern in einem Niederspannungsnetz (56), mit:
- einem Schallwandler (16) zum Erzeugen von elektrischen Signalen (18) in Abhängigkeit von aufgenommenem, sich im Boden ausbreitendem Schall (21),
- einer Steuerung (20) zum Erzeugen von Schallereignissen (25), wobei ein Schallereignis (25) einen zeitlichen Verlauf (36) eines mit dem Schallwandler (16) erzeugten elektrischen Signals (18) umfasst, das mit einem oder mehreren Zeitstempeln (22) gekennzeichnet ist, wobei die Steuerung (20) aufweist:
- einer Zeitbasis (24) zum Bereitstellen des oder der Zeitstempel (22) und
- einer Datenschnittstelle (28), die insbesondere eine Drahtlosschnittstelle ist, zur Kommunikation mit mindestens einer weiteren Kabelfehlerortungsvorrichtung (10),
wobei die Steuerung (20) eingerichtet ist, um unter Verwendung der Datenschnittstelle (28) die Zeitbasis (24) mit der mindestens einer weiteren Kabelfehlerortungsvorrichtung (10) zu synchronisieren.

2. Kabelfehlerortungsvorrichtung (10) nach Anspruch 1, wobei die Kabelfehlerortungsvorrichtung (10) einen Strahlungssensor (30) zum Erkennen von vordefinierten elektromagnetischen Impulsen und zum Wandeln eines erkannten Impulses in elektrische Auslösesignale aufweist und die Steuerung (20) eingerichtet ist, ein Schallereignis (25) mit einem vordefinierten Zeitfenster (32) des elektrischen Signals (18) nach dem Erkennen eines solchen Impulses zu erzeugen.

3. Kabelfehlerortungsvorrichtung (10) nach Anspruch 1 oder 2, wobei die Steuerung (20) eingerichtet ist, ein erzeugtes Schallereignis (25)
- zu speichern,
- an eine Auswerteeinrichtung (43), insbesondere über die Datenschnittstelle (28), zu übertragen und/oder
- an eine oder die weitere Kabelfehlerortungsvorrichtung (10), insbesondere über die Datenschnittstelle (28), vorzugsweise zur Weiterleitung an die Auswerteeinrichtung (43), zu übertragen.

4. Kabelfehlerortungsvorrichtung (10) nach einem der vorhergehenden Ansprüche, ferner umfassend eine Schrittspannungsmesseinrichtung (33), umfassend mindestens ein Paar (34) von zwei Elektroden (35), die eingerichtet sind einen Boden (19) zu kontaktieren, wobei vorzugsweise zwei Paare (34) vorgesehen sind und die Elektroden (35) der zwei Paare (34) derart angeordnet sind, dass eine Verbindungslinien der Elektroden (35) eines Paares (34) im Wesentlichen senkrecht zu einer Verbindungslinien der Elektroden (35) des anderen Paares (34) verläuft, wobei die Elektroden (35) mit der Steuerung (20) verbunden sind, um mindestens eine Spannung zwischen den Elektroden (35) des mindestens einen Paares (34) zu bestimmen und insbesondere die mindestens eine Spannung als mindestens ein Spannungsverlauf während eines Zeitfensters (32) eines Schallereignisses (25) im Schallereignis (25) darzustellen.

5. Kabelfehlerortungsvorrichtung (10) nach einem der vorhergehenden Ansprüche wobei die Kabelfehlerortungsvorrichtung (10) entweder vom Typ eines Masters (46) oder vom Typ eines Slaves (64) ist und im Fall, dass die Kabelfehlerortungsvorrichtung (10) einem Master (46) entspricht, die Datenschnittstelle (28) ein erstes Kommunikationsprotokoll zur Kommunikation mit einer weiteren Kabelfehlerortungsvorrichtung (10) und ein zweites Kommunikationsprotokoll zur Kommunikation mit einer Auswerteeinrichtung (43) unterstützt und im Fall, dass die Kabelfehlerortungsvorrichtung (10) einem Slave (64) entspricht, die Datenschnittstelle (28) nur das erste Kommunikationsprotokoll unterstützt.

6. Kabelfehlerortungsvorrichtung (10) nach einem der vorhergehenden Ansprüche, wobei ein erstes Kommunikationsprotokoll durch die Datenschnittstelle als WPAN-Schnittstelle, insbesondere ZigBee-Schnittstelle, ausgebildet ist, um mit dem ersten Kommunikationsprotokoll mit einer weiteren Kabelfehlerortungsvorrichtung (10) Daten auszutauschen, und das zweite Kommunikationsprotokoll durch die Datenschnittstelle als GSM- oder UTMS-Schnittstelle ausgebildet ist, um mit dem zweiten Kommunikationsprotokoll mit einer Auswerteeinrichtung Daten auszutauschen.

7. Kabelfehlerortungsvorrichtung (10) nach einem der vorhergehenden Ansprüche, wobei die Kabelfehlerortungsvorrichtung (10) eine Diebstahlsicherung aufweist, wobei die Diebstahlsicherung eine elektronische Diebstahlsicherung mit einem Beschleunigungssensor aufweist und vorzugsweise in Abhängigkeit von Signalen des Beschleunigungssensors ein Lautsprecher und/oder Leuchtsignal, aktivierbar ist, und/oder die Diebstahlsicherung einen Bodenanker, der elektronisch oder manuell im Boden verankerbar oder einrastbar ist, aufweist.

8. Kabelfehlerortungsvorrichtung (10) nach einem der vorhergehenden Ansprüche, wobei die Kabelfehlerortungsvorrichtung (10) einen Energiespeicher, insbesondere einen Ackumulator, aufweist, der eine Kapazität umfasst, um die Kabelfehlerortungsvorrichtung (10) vorzugsweise für mindestens 24 Stunden zu betreiben und die Kabelfehlerortungsvorrichtung (10) vorzugsweise ein Solarmodul aufweist, um den Energiespeicher zu laden.

9. Kabelfehlerortungsvorrichtung (10) nach einem der vorhergehenden, wobei die Kabelfehlerortungsvorrichtung ein Gehäuse (12) aufweist, wobei das Gehäuse (12) ausgebildet ist, um Komponenten der Kabelfehlerortungsvorrichtung (10) vor Feuchtigkeit und/oder Schmutz zu schützen und wobei das Gehäuse (12) eine Signalfarbe aufweist.

10. System (40) mit mindestens zwei, vorzugsweise drei Kabelfehlerortungsvorrichtungen (10) nach einem der Ansprüche 1 bis 9.

11. System (40) nach Anspruch 10, ferner umfassend eine Auswerteeinheit (42) zum Auswerten der mit der Kabelfehlerortungsvorrichtung (10) erzeugten Schallereignisse (25), wobei insbesondere genau ein Schallaufnehmer (10) des Systems (40) als Master (46) und ein oder mehrere Schallaufnehmer (10) als Slave (64) ausgebildet sind.

12. System (40) nach Anspruch 10 oder 11, wobei das System (40) ferner ein NH-Sicherungssystem umfasst, das über die Drahtlosverbindung mit mindestens einer oder allen Schallaufnehmern (10) des Systems (40) verbunden ist, wobei das NH-Sicherungssystem eingerichtet ist, im Fall eines Kurzschlusses in einem mit dem NH-Sicherungssystem verbindbaren Hauptkabel (56) ein Auslösesignal an die Steuerungen (20) der Kabelfehlerortungsvorrichtungen (10) zu übertragen, um eine Erfassung eines Schallereignisses (25) zu starten.

13. Verfahren zum Betreiben eines Systems (40) nach einem der Ansprüche 10 bis 12, umfassend das Synchronisieren der Zeitbasen (24) der Kabelfehlerortungsvorrichtungen (10).

14. Verfahren nach Anspruch 13, ferner umfassend mit jeder Kabelfehlerortungsvorrichtung (10) jeweils:
kontinuierliches Erzeugen von elektrischen Signalen (18) mit den Schallwandlern (16) in Abhängigkeit von sich im Boden ausbreitenden Schall (21) und Überwachen der elektrischen Signale (18) auf einen für einen Kurzschluss charakteristischen Verlauf sowie Erzeugen von Schallereignissen (25) im Fall eines erfassten charakteristischen zeitlichen Verlaufs und/oder
Betreiben der Kabelfehlerortungsvorrichtung (10) in einem Ruhemodus mit deaktiviertem Schallwandler (16) und Aktivieren des Schallwandlers (16) sowie Erzeugen von Schallereignissen (25) nach Erhalt eines Auslösesignals.

15. Verfahren nach Anspruch 13 oder 14, umfassend das Senden von Schallereignissen (25) an eine Auswerteeinheit (43) von jeder der Kabelfehlerortungsvorrichtungen (10) oder von einer als Master (46) ausgebildeten Kabelfehlerortungsvorrichtung (10).
